# EUROPÄISCHE PATENTSCHRIFT

(11) **EP 1 794 758 B1**
(45) Veröffentlichungstag und Bekanntmachung des Hinweises auf die Patenterteilung: **12.11.2008**
(21) Anmeldenummer: 05786247.6
(22) Anmeldetag: 14.09.2005
(51) Int. Cl.: G11C 14/00

(54) **NICHT-FLÜCHTIGES SPEICHERELEMENT**
NON-VOLATILE STORAGE ELEMENT
ELEMENT DE STOCKAGE NON-VOLATIL

(30) Priorität: 27.09.2004 DE 102004046793
(43) Veröffentlichungstag der Anmeldung: 13.06.2007
(73) Patentinhaber: Austriamicrosystems AG, A-8141 Unterpremstätten (AT)
(72) Erfinder: SCHATZBERGER, Gregor, A-8052 Graz (AT)
(74) Vertreter: Epping - Hermann - Fischer
(86) Internationale Anmeldenummer: PCT/EP2005/009881
(87) Internationale Veröffentlichungsnummer: WO 2006/034782

(56) Entgegenhaltungen:
- US-A- 5 523 971
- US-A- 5 757 696
- US-A1- 2002 031 028

## Beschreibung

Die Erfindung betrifft ein nicht-flüchtiges Speicherelement.

Speicherelemente, wie sie im Rahmen der vorliegenden Anmeldung beschrieben werden, werden häufig als "Latch" bezeichnet. Es handelt sich um wiederbeschreibbare, nicht-flüchtige Speicherelemente, die für die Speicherung kleiner Datenmengen eingesetzt werden. In der Regel handelt es sich dabei um eine Datenmenge von 1 Bit bis zu einigen 100 Bits. Die Daten bleiben erhalten, auch wenn die Stromversorgung des Speicherelements abgeschaltet wird. In integrierten elektronischen Schaltkreisen wird häufig eine Vielzahl derartige Speicherelemente eingesetzt. Die für ein Speicherelement verbrauchte Fläche sollte daher so klein wie möglich sein.

Nicht-flüchtige Speicher sind bereits bekannt. In diesen nicht-flüchtigen Standard-Speichern wird eine komplexe Adressierung mit entsprechend aufwändigen Schaltungskomponenten eingesetzt. Zudem ist ein Leseverstärker erforderlich, um Daten aus dem nicht-flüchtigen Speicher auslesen zu können. Der Einsatz von nicht-flüchtigen Standard-Speichern ist daher verhältnismäßig aufwändig und verbraucht eine große Fläche.

Aus der US 6,411,545 ist ein nicht-flüchtiger Latch-Speicher bekannt, bei dem ein Source-gekoppeltes Speicherelement und zwei Schreibeingänge auf der Hochspannungsseite sowie ein isolierter Datenausgang vorgesehen sind.

Die US 5,648,930 offenbart einen nicht-flüchtigen Latch-Speicher mit Drain-gekoppelten Speicherelementen, wie sie typischerweise in einem RAM vorgesehen sind. Die Latch-Speicher weisen einen Dateneingang und einen Datenausgang auf. Sie werden über Versorgungsleitungen programmiert.

Die US 5,523,971 offenbart einen nicht-flüchtigen Latchspeicher bestehend aus acht Transistoren. Während des Programmiervorgangs wird der nicht-flüchtige Latchspeicher von der Versorgungsspannung isoliert.

Aus der US 4,132,904 ist ein nicht-flüchtiger Latch-Speicher bekannt, der allerdings den Nachteil aufweist, dass die wieder ausgelesenen Daten gegenüber den zuvor geschriebenen Daten nur in invertierter Form vorliegen.

Die US 4,348,745 offenbart einen nicht-flüchtigen Latch-Speicher, der zwölf Transistoren sowie eine Programmierspannung von 17 V benötigt, sodass dieser Latch-Speicher verhältnismäßig aufwändig ist.

Aus der US 5,757,696 ist ein nicht-flüchtiges Speicherelement nach dem Oberbegriff des Anspruchs 1 bekannt.

Die Aufgabe der vorliegenden Erfindung besteht darin, ein nicht-flüchtiges Speicherelement anzugeben, das einfach im Aufbau ist und wenig Platz beansprucht.

Diese Aufgabe wird durch ein nicht-flüchtiges Speicherelement gemäß Patentanspruch 1 gelöst.

Ein nicht-flüchtiges Speicherelement nach der Erfindung setzt demnach ein erstes Transistor-Paar mit Floating-Gate-MOS-Transistoren ein, wobei jeweils das Floating-Gate kapazitiv mit dem Drain-Anschluss des anderen Transistors des Transistor-Paars verbunden ist. Die Source-Anschlüsse der Floating-Gate-Transistoren sind mit einem zweiten Transistor-Paar des gleichen Leitfähigkeitstyps verbunden. Die Gate-Anschlüsse dieses Transistor-Paars sind miteinander verbunden. Im Schreib-Modus werden die Gate-Anschlüsse so angesteuert, dass beide Transistoren hochohmig sind und so die Floating-Gate-Transistoren von der Standard-Niederspannungsversorgung trennen. Um ein sicheres Trennen von der Standard-Niederspannungsversorgung zu erreichen, werden die Well-Anschlüsse des zweiten Transistor-Paares während des Schreibens auf das höchste Potential gelegt. In einem Lese-Modus werden beide Transistoren so angesteuert, dass sie niederohmig sind, die Well-Anschlüsse des Transistor-Paares sind dann mit der Niederspannungsversorgung verbunden. Die Drain-Anschlüsse der Floating-Gate-Transistoren sind mit den Drain-Anschlüssen eines dritten Transistor-Paars verbunden, wobei dessen Transistoren den entgegengesetzten Leitfähigkeitstyp aufweisen. Die Gate-Anschlüsse des dritten Transistor-Paares sind kreuzgekoppelt mit den Drain-Anschlüssen des jeweils anderen Transistors. Das erfindungsgemäße Speicherelement benötigt nur wenige Transistoren und ist einfach ansteuerbar, da zum Schreiben nur eine Spannungsbedingung erforderlich ist, um sowohl das eine Floating-Gate zu laden als auch das andere zu entladen.

In einer ersten Weiterbildung der Erfindung sind die Drain-Anschlüsse der Flooting-Gate-Transistoren mit einem vierten Transistor-Paar des gleichen Leitfähigkeitstyps verbunden, die zwischen das erste Transistor-Paar und das dritte Transistor-Paar geschaltet sind. Die Gate-Anschlüsse der Transistoren des vierten Transistor-Paars sind miteinander verbunden. Zwischen den Transistoren des dritten und vierten Transistor-Paares sind Datenanschlüsse vorgesehen, die Datenausgänge bilden. Im Schreib-Modus werden die Gate-Anschlüsse so angesteuert, dass beide Transistoren hochohmig sind und dadurch die Floating-Gate-Transistoren von den Datenausgängen trennen. Dazu werden die Well-Anschlüsse des Transistor-Paares während des Schreib-Modus auf das höchste Potential geschaltet. Im Lese-Modus werden beide Transistoren so angesteuert, dass ihre Kanäle niederohmig sind. Die Well-Anschlüsse des Transistor-Paares sind dabei mit der Standard-Niederspannungsversorgung verbunden. Die Transistoren des zweiten und vierten Transistor-Paares werden mit dem gleichen Signal angesteuert. Somit ist eine Trennung der Ausgänge und der Standard-Niederspannungsversorgung von einer im Schreib-Modus an den Eingängen anliegenden Hochspannung sichergestellt.

In einer zweiten Weiterbildung der Erfindung sind parallel zu jedem Transistor des dritten Transistor-Paares weitere Transistoren des gleichen Leitungstyps angeordnet. Im Schreib-Modus werden diese Transistoren so angesteuert, dass die Ausgänge des Speicherelements gegenüber dem Bezugspotenzial kurzgeschlossen sind. Im Lese-Modus werden beide Transistoren so angesteuert, dass sie nicht-leitend sind. Die Gate-Anschlüsse beider Transistoren sind miteinander verbunden.

Im Schreib-Modus sind die Floating-Gate-Transistoren sowohl von der Standard-Niederspannungsversorgung als auch von den Ausgängen durch die hochohmigen Transistoren des zweiten und vierten Transistor-Paares getrennt. Daten können in das Speicherelement geschrieben werden, indem eine moderate Hochspannung an den Drain-Anschluss, den Source-Anschluss und das Substrat des ersten und an den Gate-Anschluss des zweiten Floating-Gate-Transistors angelegt werden. Bei dem zweiten Floating-Gate-Transistor werden der Drain-Anschluss, der Source-Anschluss und das Substrat sowie bei dem ersten Floating-Gate-Transistor der Gate-Anschluss auf Masse gelegt. Diese Spannungsverhältnisse ermöglichen, dass einerseits Elektronen von den Drain-, Source- und Substrat-Bereichen zu dem Floating-Gate des zweiten Floating-Gate-Transistors tunneln und andererseits an dem ersten Floating-Gate-Transistor Elektronen von dem Floating-Gate zu den Drain-, Source- und Substrat-Bereich tunneln. Diese Stromflüsse führen zu einer positiven Ladung des Floating-Gates des ersten Transistors und zu einer negativen Ladung des Floating-Gates des zweiten Transistors. Die Ausgänge des Speicherelements sind derweil kurzgeschlossen.

Im Lese-Modus werden das zweite und vierte Transistor-Paar leitend geschaltet, indem die Gate-Anschlüsse mit Masse verbunden werden. Während des Schreib-Modus ist das fünfte Transistor-Paar, welches die Ausgänge gegenüber Masse kurzschließt, geöffnet. Wenn alle Spannungsbedingungen wie beschrieben vorliegen, bildet die beschriebene Struktur zwei rückgekoppelte Inverter, die unterschiedliche Ansprechpunkte je nach der Ladung auf den Floating-Gates aufweisen. Ein Floating-Gate-Transistor beginnt vor dem anderen zu leiten mit dem Ergebnis, dass die rückgekoppelten Inverter in einen Zustand gehen, in dem ein Ausgang auf High und der andere Ausgang auf Low ist.

Eine Anordnung mit zeitlicher Selbststeuerung kann mit dem Speicherelement gemäß der zweiten Weiterbildung der Erfindung durch Verwendung eines zusätzlichen ODER-Gatters realisiert werden, das mit den Datenausgängen des Speicherelements verbunden ist. Im Schreib-Modus werden, wie oben beschrieben, die Ausgänge auf Masse gezogen, sodass der Ausgang des ODER-Gatters ebenfalls auf Masse liegt. Im Lese-Modus liegt ein Ausgang spannungsmäßig auf der Betriebsspannung (High) und der andere liegt auf Masse (Low) entsprechend der Ladung auf den Floating-Gates des ersten und zweiten Floating-Gate-Transistors. Ein Wechsel an den Ausgängen des Speicherelements verursacht also einen Wechsel am Ausgang des ODER-Gatters von Masse (Low) auf das Betriebsspannungspotent ial (High).

Mit dem Ausgangssignal des ODER-Gatters und einigen zusätzlichen Logikbausteinen kann ein automatischer Stromsparmodus des nicht-flüchtigen Speicherelements implementiert werden. Der Stromsparmodus hat den Vorteil eines besseren Datenerhaltungsverhaltens des nicht-flüchtigen Speicherelements verglichen zu dem normalen Lese-Modus. Der automatische Stromsparmodus wird unten anhand eines Ausführungsbeispiels näher erläutert.

Das erfindungsgemäße Speicherelement bildet ein nicht-flüchtiges Speicherelement, das im Schreib-Modus, im Stromspar-Modus und auch im Lese-Modus, nachdem die Ausgänge des Speicherelement den programmierten Zustand eingenommen haben, nur einen Leckstrom verbraucht.

Das erfindungsgemäße Speicherelements weist in seinen verschiedenen Ausgestaltungen eine Reihe von Vorteilen auf. Ein erster Vorteil ist, dass nach dem Einschalten an seinen Ausgängen ein logisches Signal entsprechend den Ladungen auf den Floating-Gate-Transistoren anliegt. Ein zweiter Vorteil besteht darin, dass während des Schreib-Modus die Speicherzellen vollständig von der normalen Niederspannungsversorgung und den Datenausgängen isoliert sind. Ein dritter Vorteil besteht darin, dass das Auslesen der Speicherzellen mit einer zeitlichen Selbststeuerung erfolgt. Das bedeutet, dass das Speicherelement in der Lage ist, selber zu erkennen, wenn eine logische Entscheidung erfolgt ist. Ein weiterer Vorteil der Erfindung besteht darin, dass die Ausgangsspannung des nicht-flüchtigen Speicherelementes in dem Schreib- und Lesemodus immer innerhalb des Bereichs der Niederspannungsversorgung liegt. Im Lese-Modus tritt kein Spannungsabfall Vₜₕ auf. Im Schreib-Modus tritt keine Hochspannung, wie sie zur Programmierung eingesetzt wird, an den Datenausgängen des nicht-flüchtigen Speicherelementes auf, sodass an den Ausgängen des Speicherelementes normale Standard-Logik-Elemente eingesetzt werden können.

Weiter vorteilhafte Ausgestaltungen der Erfindung sind in Unteransprüchen angegeben. Die Erfindung wird nachfolgend anhand von Ausführungsbeispielen näher erläutert. Es zeigt:
Figuren 1 und 2 elektrische Schaltbilder eines erfindungsgemäßen nicht-flüchtigen Speicherelements mit Trennung der Floating-Gate-Transistoren von der positiven Versorgungsspannung,
Figuren 3 und 4 elektrische Schaltbilder eines weitergebildeten nicht-flüchtigen Speicherelements mit zusätzlicher Trennung der Floating-Gate-Transistoren von den Datenausgängen,
Figur 5 ein elektrisches Schaltbild eines weitergebildeten nicht-flüchtigen Speicherelements mit einer Precharge-Vorrichtung,
Figur 6 ein Signaldiagramm, in dem der Verlauf von Signalen der Schaltung von Figur 5 dargestellt ist,
Figur 7 ein elektrisches Schaltbild eines weitergebildeten nicht-flüchtigen Speicherelements mit einer Kontrolle der Ausgangspegel im Schreib-Modus,
Figur 8 eine Anordnung mit dem Speicherelement von Figur 7, einem ODER-Gatter und einem Flip-Flop zur Bildung einer zeitlichen Selbststeuerung und
Figur 9 ein Signaldiagramm, in dem der Verlauf von Signalen der Schaltung von Figur 8 dargestellt ist.

Im folgenden wird die Erfindung anhand beispielhafter Ausführungsformen beschrieben, wobei die Ausführungsbeispiele in keiner Weise beschränkend sind. Weitere Ausführungsformen der Erfindung sind möglich und von den Ansprüchen umfasst.

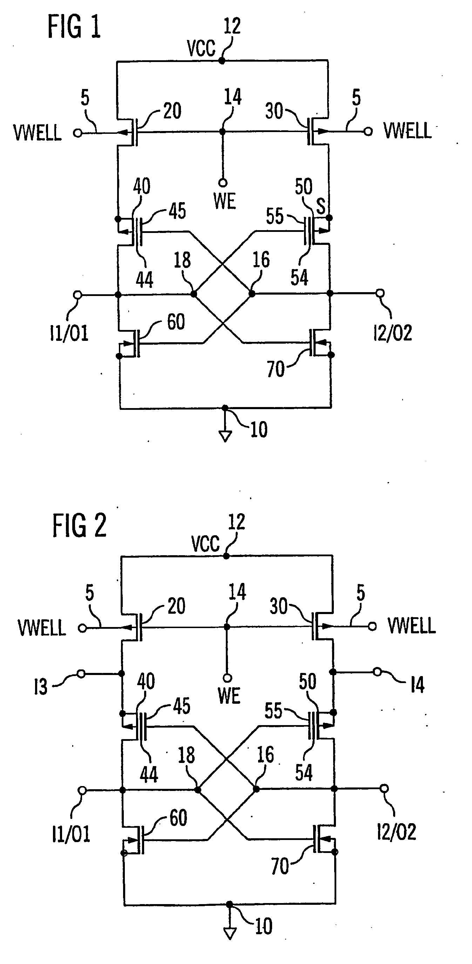

Die Figuren 1 und 2 zeigen zwei Schaltbilder für Speicherelemente gemäß der vorliegenden Erfindung. Die Schaltung umfasst ein Transistor-Paar mit p-Kanal-Transistoren 40 und 50, die jeweils Floating-Gates 44 und 54 haben. Die Transistoren 40 und 50 haben Steuer-Gates 45 und 55, welche kapazitiv mit den Floating-Gates 44 und 54 verbunden sind. Das Steuer-Gate 45 des ersten Floating-Gate-Transistors 40 ist mit dem Drain-Anschluss des anderen Floating-Gate-Transistors 50 verbunden, während der Steuer-Gate-Anschluss 555 des Transistors 50 mit dem Drain-Anschluss des Transistors 40 verbunden ist, sodass sich eine kreuzgekoppelte Anordnung ergibt. Die Source-Anschlüsse der Floating-Gate-Transistoren 40 und 50 sind mit ihrem eigenen n-Substrat verbunden.

Ein dritter und vierter Transistor 20 und 30 bilden ein zweites Transistor-Paar, deren Drain-Anschlüsse mit den Source-Anschlüssen der Transistoren 40 und 50 verbunden sind. Die Source-Anschlüsse des zweiten Transistor-Paares sind mit einem Versorgungsspannungsanschluss 12 verbunden und dadurch mit einer Versorgungsspannung VCC beaufschlagt. Die Gate-Anschlüsse sind miteinander verbunden und an eine erste Steuersignalleitung 14 angeschlossen, wodurch sie mit einem ersten Steuersignal WE beaufschlagt werden können. Zur Erzeugung des Steuersignals WE ist eine externe, nicht dargestellte Steuereinheit vorgesehen.

Die Well-Anschlüsse sind miteinander verbunden und an eine dritte Steuersignalleitung 5 angeschlossen. Im Schreib-Modus liegt an diesem Anschluss eine moderate Hochspannung an, die auch zum Programmieren der Floating-Gate-Transistoren verwendet wird. Im Lese-Modus werden die Well-Anschlüsse mit der Standard-Niederspannungsversorgung VCC verbunden. Zur Erzeugung des Steuersignals VWELL wird eine externe, nicht dargestellte Steuereinheit verwendet.

Die Drain-Anschlüsse der Transistoren 40 und 50 sind mit den Drain-Anschlüssen eines dritten Transistor-Paares mit einem fünften Transistor 60 und einem sechsten Transistor 70 verbunden. Die Drain-Anschlüsse des ersten und fünften Transistors 40 und 60 sowie der Gate-Anschluss des sechsten Transistors 70 sind mit einem ersten Datenanschluss I1/O1 verbunden, der sowohl einen Dateneingang als auch einen Datenausgang bildet. Entsprechend sind die Drain-Anschlüsse des zweiten und sechsten Transistors 50 und 70 sowie der Gate-Anschluss des fünften Transistors 60 mit einem zweiten Datenanschluss I2/O2 verbunden, der ebenfalls sowohl einen Dateneingang als auch einen Datenausgang bildet. Die Source-Anschlüsse des dritten Transistor-Paares sind mit dem Bezugspotentialanschluss 10 verbunden.

Beim Ausführungsbeispiel der Figuren 1 und 2 werden im Schreib-Modus, abhängig von der gewünschten Programmierung, die Programmierspannung am ersten Datenanschluss I1/O1 oder am zweiten Datenanschluss I2/O2 eingeprägt. Im Lese-Modus wird das Ausgangssignal am ersten Datenanschluss I1/O1 von den Drain-Anschlüssen der Transistoren 40 und 60 bestimmt, während das Signal am zweiten Datenanschluss I2/O2 von den Drain-Anschlüssen der Transistoren 50 und 70 bestimmt wird.

Im Schreib-Modus ist der erste Versorgungsspannungsanschluss 12 mit einer Versorgungsspannung VCC beaufschlagt, die der Standardbetriebsspannung gemäß der verwendeten Technologie entspricht. Das Steuersignal WE am ersten Steueranschluss 14 und das Steuersignal VWELL an der dritten Steuersignalleitung 5 werden durch eine Programmierspannung VPP gebildet, sodass der dritte Transistor 20 und der vierte Transistor 30 nicht-leitend sind. Abhängig von dem Kopplungsfaktor zwischen den Floating-Gates und den Steuer-Gates sowie der Dicke der Tunnel-Oxid-Schicht beträgt die Programmierspannung 10 V bis 14 V. Um Datensignale in dem Speicherelement zu speichern, muss die Spannung am ersten Datenanschluss I1/O1 auf die Programmierspannung VPP gelegt werden. Wenn dies der Fall ist, wird der n-Kanal-Transistor 70 leitend, der Floating-Gate-Transistor 50 wird nicht-leitend und der zweite Datenanschluss I2/O2 wird auf Masse gezogen. Mit dem auf Masse liegenden Anschluss I2/O2 wird der erste Floating-Gate-Transistor 40 leitend, während der n-Kanal-Transistor 60 nicht-leitend ist. Dabei fließt kein Gleichstrom durch die Speicherelement-Anordnung. Das Steuer-Gate 45 des Floating-Gate-Transistors 40 wird auf Masse gezogen, die Spannung kann aber auch von außen über den zweiten Datenanschluss I2/O2 eingeprägt sein. Das Steuer-Gate 55 des zweiten Floating-Gate-Transistors 50 liegt derweilen auf der Programmierspannung VPP. Die Potenzialdifferenz veranlasst Elektronen, von dem Floating-Gate 44 zu dem Kanal des Transistors 40 zu tunneln, sodass das Floating-Gate positiv geladen wird.

Zur gleichen Zeit wird das Steuer-Gate 55 des zweiten Floating-Gate-Transistors 50 mit der Programmierspannung VPP beaufschlagt und der Drain-Anschluss wird auf Masse gezogen. Die Potenzialdifferenz zwischen dem Steuer-Gate 55 und dem Floating-Gate 54 bewirkt, dass Elektronen von dem Drain-Bereich zu dem Floating-Gate 54 tunneln und es dadurch negativ aufladen.

Aufgrund der Symmetrie des Schaltkreises ist zum Schreiben nur eine Spannungsbedingung erforderlich, um sowohl das eine Floating-Gate zu laden als auch das andere zu entladen.

In dem Ausführungsbeispiel von Figur 2 sind zwei zusätzliche Datenanschlüsse I3 und I4 vorgesehen, die Dateneingänge bilden und daher im folgenden auch als Eingangsanschlüsse bezeichnet werden. In dem Schreib-Modus ist der Datenanschluss I3 mit dem Datenanschluss I1/O1 niederohmig verbunden, während der Datenanschluss I4 niederohmig mit dem Datenanschluss I2/O2 verbunden ist. Somit weisen beide Substrate das Potenzial für den Schreib-Modus auf. Wenn Daten in der beschriebenen Weise in das Speicherelement geschrieben werden, fließt ein Tunnelstrom von dem Kanal des einen Transistors zu dem zugehörigen Floating-Gate und von dem Floating-Gate des anderen Transistors zu dem diesem zugehörigen Kanal.

Am Ende des Schreibzugriffs ist gemäß dem beschriebenen Beispiel das Floating-Gate 44 des ersten Transistors 40 positiv und das Floating-Gate 54 des zweiten Transistors 50 negativ geladen.

In dem Lese-Modus wird das Steuersignal VWELL auf die Versorgungsspannung VCC geschaltet, das Steuersignal WE wird auf Masse gelegt und das zweite Transistor-Paar mit den Transistoren 20 und 30, das mit dem ersten Versorgungsspannungsanschluss 12 verbunden ist, wird leitend. Der Transistor mit dem positiv geladenen Floating-Gate leitet nicht, der Transistor mit dem negativ geladenen Floating-Gate ist leitend. In dem zuvor beschriebenen Beispiel sind die Transistoren 20 und 30 leitend, wenn das Steuersignal WE auf Masse gelegt ist und das Steuersignal VWELL mit der Versorgungsspannung VCC verbunden ist. Der zweite Transistor 50 ist leitend und der erste Transistor 40 ist nicht-leitend. Der Strom, der durch den zweiten Transistor 50 fließt, lädt den Knoten 16 am zweiten Datenanschluss I2/O2 positiv auf, sodass der fünfte Transistor 60 leitend wird. Das Steuer-Gate 55 des Transistors 50 wird dadurch auf Masse gezogen, weil der Transistor 40 nicht-leitend ist. Wenn das Steuer-Gate 55 auf Masse liegt, ist der Transistor 70 nicht-leitend, und das Steuer-Gate 45 ist mit der vollen Spannung VCC am ersten Versorgungsanschluss 12 beaufschlagt.

Wurden die Floating-Gates anders herum geladen, indem die Eingangssignale an den Datenanschlüssen I1/O1 und I2/O2 vertauscht wurden, so ergeben sich im Lese-Modus auch als Ausgangssignale an den Datenanschlüssen I1/O1 und I2/O2 umgekehrte Signalzustände.

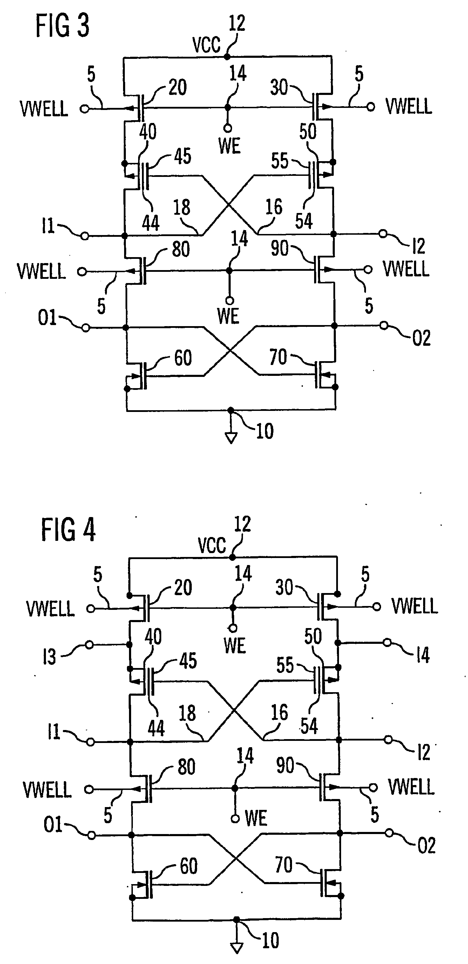

Die Figuren 3 und 4 zeigen eine weitergebildete Schaltungsanordnung der vorliegenden Erfindung. Während der erste und zweite Datenanschluss I1/O1 und I2/O2 bei der Ausführung nach den Figuren 1 und 2 jeweils sowohl eine Funktion als Dateneingang als auch als Datenausgang hat, sind bei den Ausführungen nach den Figuren 3 und 4 zusätzliche, getrennte Datenanschlüsse vorgesehen. Die Datenanschlüsse, die mit den Drain-Anschlüssen der Floating-Gate-Transistoren 40 und 50 verbunden sind und die in den Figuren 1 und 2 mit I1/O1 und I2/O2 bezeichnet sind, haben bei den im folgenden beschriebenen Speicherelementen nur eine Funktion als Dateneingang und werden daher im Rahmen dieses Ausführungsbeispiels auch als Eingangsanschlüsse bezeichnet und mit den Bezugszeichen I1 und I2 versehen, während separate Datenanschlüsse O1 und O2 vorgesehen sind, die Datenausgänge bilden und daher im folgenden auch als Ausgangsanschlüsse bezeichnet werden. Dadurch können die Ausgänge O1 und O2 von der Programmierspannung VPP getrennt werden.

Dazu ist in beiden gezeigten Schaltungsanordnungen ein zusätzliches viertes Transistor-Paar vorgesehen, das aus p-Kanal-Transistoren 80 und 90 besteht. Verglichen mit dem zweiten Transistor-Paar mit den Transistoren 20 und 30, das die Floating-Gate-Transistoren 40 und 50 von der Versorgungsspannung am ersten Versorgungsspannungsanschluss 12 trennt, sind die Transistoren 80 und 90 in analoger Weise angeordnet. Die Gate-Anschlüsse der zusätzlichen Transistoren 80 und 90 sind miteinander verbunden und werden ebenfalls durch das Steuersignal WE, das über die Steuersignalleitung 14 zugeführt wird, angesteuert. Die Well-Anschlüsse der beiden Transistoren sind miteinander verbunden und werden ebenfalls durch das Steuersignal VWELL, das durch die Steuersignalleitung zugeführt wird, angesteuert. Die Source-Anschlüsse dieser beiden Transistoren sind mit den Drain-Anschlüssen der kreuzgekoppelten Floating-Gate-Transistoren 40 und 50 verbunden. Die Drain-Anschlüsse der Transistoren 80 und 90 sind mit den Drain-Anschlüssen der kreuzgekoppelten n-Kanal-Transistoren 60 und 70 verbunden.

Im Schreib-Modus liegen die Steuersignale WE und VWELL auf der Programmierspannung VPP und das zweite und vierte Transistor-Paar mit den Transistoren 20, 30, 80 und 90 sind nicht-leitend. Die kreuzgekoppelten Floating-Gate-Transistoren 40 und 50 sind vollständig von der Versorgungsspannung VCC am ersten Versorgungsspannungsknoten 12 getrennt. Außerdem sind sie von den Ausgangsanschlüssen O1 und O2 getrennt. Die Spannungen an den beiden Eingangsanschlüssen I1 und I2 müssen von außen festgelegt werden, wie oben beschrieben wurde. Mit den von der Programmierspannung VPP getrennten Ausgängen können die kreuzgekoppelten n-Kanal-Transistoren 60 und 70 als Standard-Niederspannungstransistoren implementiert werden, sodass sie in einem Basisprozess hergestellt werden können. Die Ausgangspegel an den Ausgangsanschlüssen O1 und O2 liegen immer innerhalb eines Niederspannungsbereichs zwischen Masse und der Versorgungsspannung. Logikbausteine, die an den Ausgängen des Speicherelementes angeschlossen sind, können daher mit Standard-Logikgattern implementiert werden, die ebenfalls im Basisprozess herstellbar sind.

In Figur 4 sind Eingangsanschlüsse I3 und I4 ergänzt. In dem Schreib-Modus ist der Eingangsanschluss I3 niederohmig mit dem Eingangsanschluss I1 verbunden und der Eingangsanschluss I4 ist niederohmig mit dem Eingangsanschluss I2 verbunden. In dem Lese-Modus sind beide Eingänge auf einem schwebenden Potenzial.

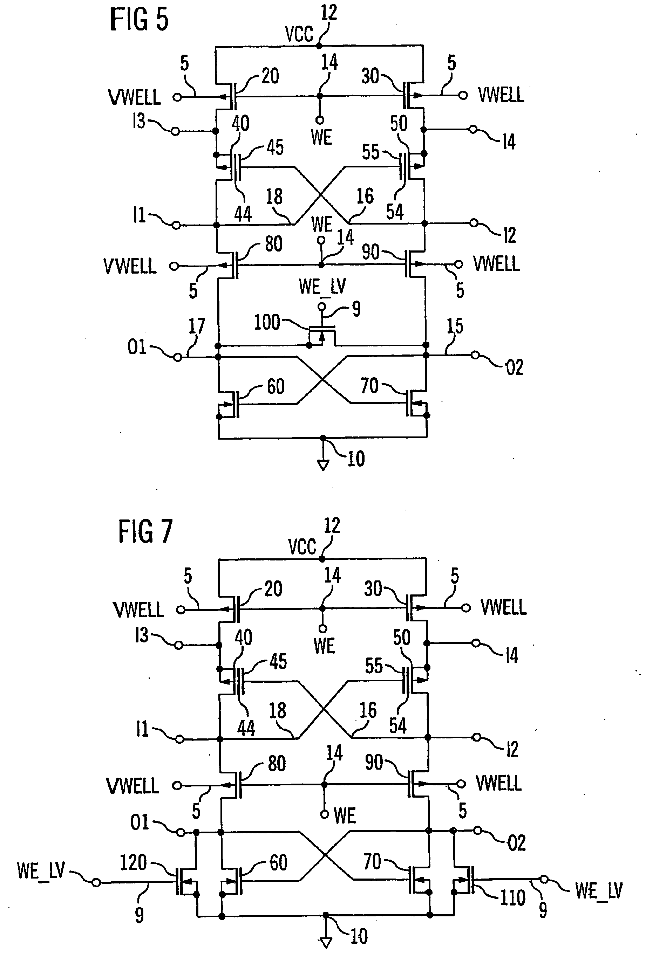

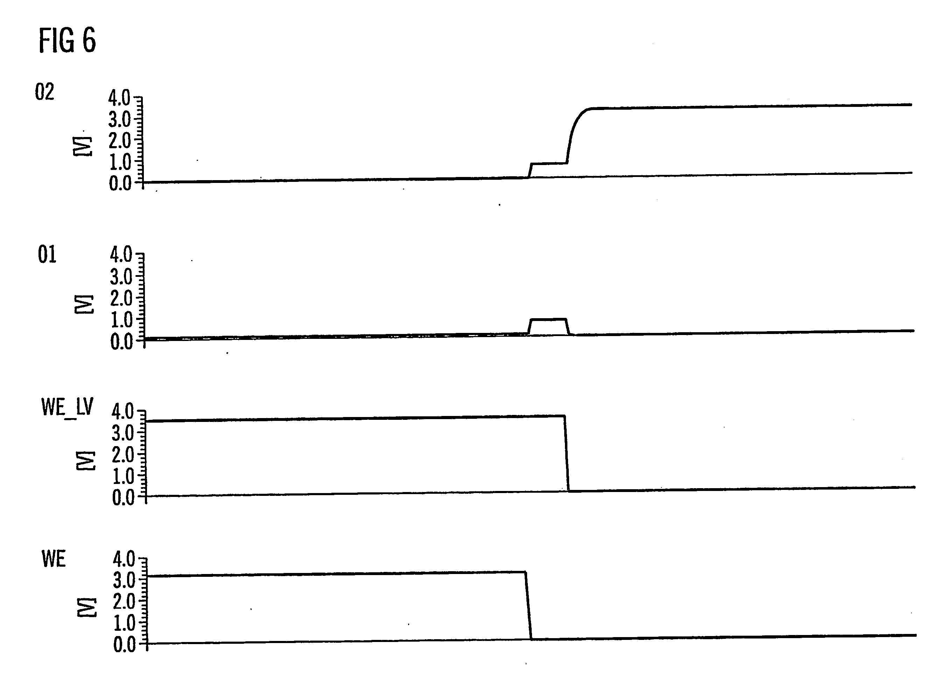

Die Figur 5 zeigt eine Schaltungsanordnung gemäß einer weiter verbesserten Ausführung der vorliegenden Erfindung mit einem Precharge-Ansatz, um ein empfindlicheres Speicherelement zu erhalten. Verglichen mit der Schaltungsanordnung von Figur 4 ist ein zusätzlichen n-Kanal-Transistor 100 vorgesehen. Der Drain-Anschluss dieses Transistors ist mit dem Ausgangsanschluss O2 und der Source-Anschluss mit dem Ausgangsanschluss O1 verbunden. Das Gate wird über eine zweite Steuersignalleitung 9 mit einem zweiten Steuersignal WE_LV beaufschlagt, das ebenfalls von der externen Steuereinheit erzeugt wird. Die zeitlichen Verläufe der Steuersignale WE und WE_LV sowie der Signale an den Ausgangsanschlüssen O1 und O2 sind in der Figur 6 dargestellt.

In dem Schreib-Modus liegt das Steuersignal WE_LV auf der Versorgungsspannung VCC, der Transistor 100 ist leitend und die Ausgangsanschlüsse O1 und O2 sind niederohmig miteinander verbunden. Somit haben beide Ausgangsanschlüsse O1 und O2 das gleiche Potenzial. Die Daten werden in dem nicht-flüchtigen Speicherelement, wie anhand von Figur 4 beschrieben, gespeichert. Zum Umschalten von dem Schreib-Modus in den Lese-Modus wird das Signal WE auf Masse gelegt, das Steuersignal VWELL auf die Versorgungsspannung VCC gelegt und die Transistoren 20, 30, 80 und 90 des zweiten und vierten Transistor-Paars sind leitend. Der Floating-Gate-Transistor 40 ist positiv geladen und der Transistor 50 negativ geladen. Der Floating-Gate-Transistor 50 wird dadurch leitend und das Potenzial an den Ausgangsanschlüssen O1 und O2 steigt. Das kreuzgekoppelte Transistor-Paar mit den Transistoren 60 und 70 wird somit leitend. Mit einer kleinen Verzögerung wird das zweite Steuersignal WE_LV auf Masse gelegt. Das Gate des n-Kanal-Transistors 60 wird mit VCC angesteuert und der Ausgangsanschluss O1 somit auf Masse gezogen. Mit dem auf Masse liegenden Ausgangsanschluss O1 wird der n-Kanal-Transistor 70 nicht-leitend und der zweite Ausgangsanschluss 02 wird auf VCC angehoben.

Mit der oben beschriebenen Schaltungsanordnung können sehr kleine Ladungsdifferenzen auf den Floating-Gates der Transistoren 40 und 50 ausgewertet werden. Dadurch erhöht sich bei Ausgestaltung eines Speicherelements nach diesem Ausführungsbeispiel die Geschwindigkeit des Auslesens.

Die Figur 7 zeigt ein Ausführungsbeispiel der erfindungsgemäßen Schaltungsanordnung mit einem zeitlich selbstgesteuerten Ansatz zur Bereitstellung eines Speicherelements, das auf sehr einfache Weise einen Signalwechsel an seinen Ausgängen feststellen kann. Das beschriebene, nicht-flüchtige Speicherelement ist im Vergleich zu der Schaltungsanordnung von Figur 4 ebenfalls empfindlicher gegenüber kleinen Ladungsunterschieden auf den Floating-Gates. Ein Vergleich zwischen der Schaltungsanordnung in Figur 5 und der Schaltungsanordnung in Figur 7 zeigt, dass zwei zusätzliche n-Kanal-Transistoren 110 und 120 vorgesehen sind. Der neunte Transistor 100 ist nicht mehr vorgesehen. Der Drain-Anschluss des Transistors 120 ist mit dem Ausgangsanschluss O1 und der Source-Anschluss ist mit Masse verbunden. Der Drain-Anschluss des Transistors 110 ist mit dem Ausgangsanschluss O2 und der Source-Anschluss ist mit Masse verbunden. Die Gate-Anschlüsse der beiden Transistoren 110 und 120 sind über zweite Steuersignalleitungen 9 mit dem zweiten Steuersignal WE_LV beaufschlagt.

In dem Schreib-Modus liegt das Steuersignal WE_LV auf der Versorgungsspannung VCC, beide Transistoren 110 und 120 sind leitend und die Ausgänge liegen auf Masse. Daten können in der anhand von Figur 4 beschriebenen Weise in das Speicherelement geschrieben werden. In dem beschriebenen Beispiel ist der Floating-Gate-Transistor 50 negativ geladen und das Floating-Gate des Transistors 40 positiv geladen.

Am Ende eines Schreib-Pulses geht das Signal WE auf Massepotenzial, das Steuersignal VWELL auf die Versorgungsspannung und das zweite und das vierte Transistor-Paar mit den Transistoren 20, 30, 80 und 90 wird leitend. Wenn das zweite Steuersignal WE_LV auf VCC geht, geht das Potenzial an den jeweiligen Drain- und Gate-Anschlüssen der Floating-Gate-Transistoren 40 und 50 auf Masse. Der Transistor 50 ist leitend und der Transistor 40 ist nicht-leitend.

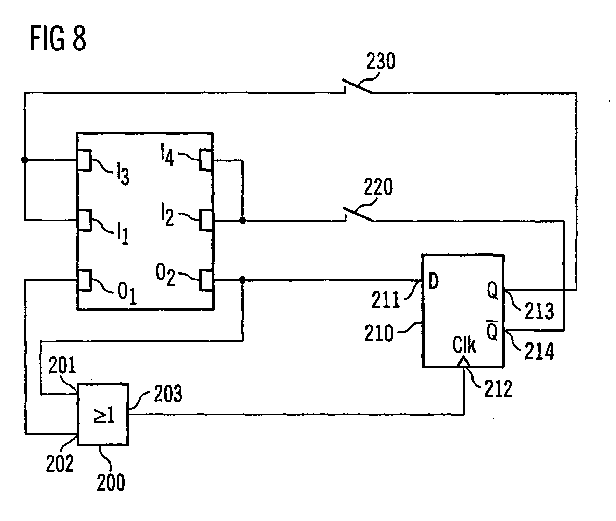

In der Figur 8 ist eine Schaltung dargestellt, bei der das bisher beschriebene Speicherelement durch eine einfache Beschaltung ergänzt ist. Dabei sind die beiden Ausgangssignale des nicht-flüchtigen Speicherelementes auf ein einfaches ODER-Gatter 200 geführt. Das Ausgangssignal des ODER-Gatters 200 ist "0", wenn beide Eingangssignale auf "0" sind.

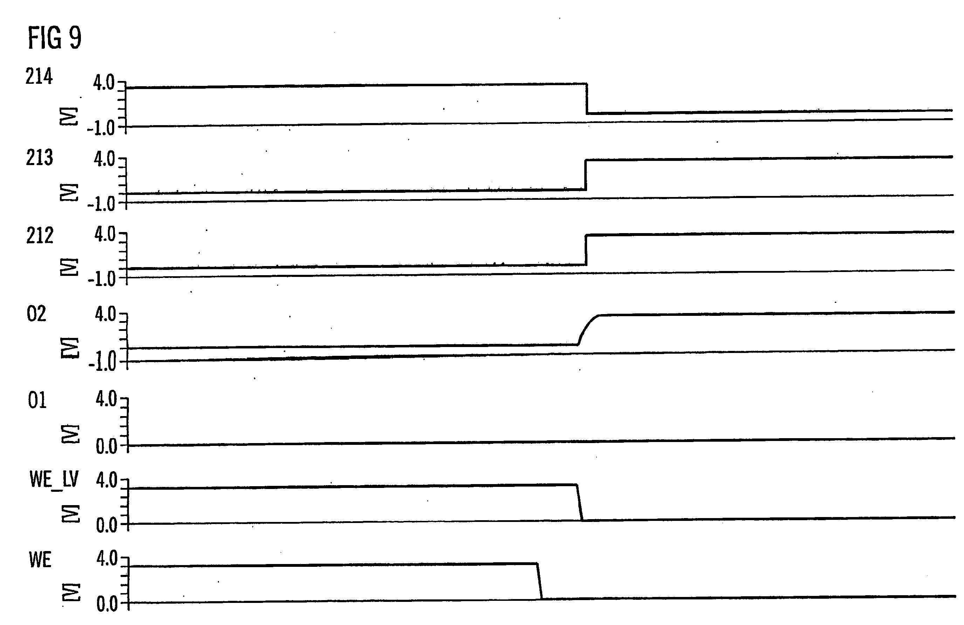

Nachdem am Ende eines Schreib-Pulses das erste Steuersignal WE auf Massepotenzial und das dritte Steuersignal auf die Versorgungsspannung gegangen ist, geht nach einer kurzen Verzögerung auch das zweite Steuersignals WE_LV auf Masse. Die zeitlichen Abläufe bei sind in der Figur 9 dargestellt. Die Spannung am zweiten Ausgangsanschluss 02 steigt dadurch auf VCC, während die Spannung am ersten Ausgangsanschluss 01 auf Masse sinkt. Dies bewirkt, dass das Ausgangssignal des ODER-Gatters von "0" nach "1" wechselt, weil nun eines der Eingangssignale auf "1" und das andere auf "0" liegt. Somit kann einen Signalwechsel an den Ausgängen des beschriebenen Speicherelements festgestellt werden.

Diese Tatsache kann dazu genutzt werden, um das nicht-flüchtige Speicherelement in einen Stromsparmodus zu versetzen, nachdem die gespeicherten Daten zu einem mit dem Speicherelement verbundenen Standard-Flip-Flop 210 übertragen wurden. Beispielsweise kann das Ausgangssignal des ODER-Gatters 200 ein Flip-Flop 210 triggern, welches die Daten des nicht-flüchtigen Speicherelements übernimmt, wie in der Figur 8 dargestellt ist.

Zur Erläuterung der Funktionsweise wird angenommen, dass der Pegel am ersten Ausgangsanschluss O1 auf "0" und am zweiten Ausgangsanschluss O2 auf "1" liegt. Am D-Eingang 211 des Flip-Flops 210 liegt entsprechend dem verbunden Ausgangsanschluss O2 eine "1" an. Die beiden Ausgangssignale des Speicherelements sind durch das ODER-Gatter 200 verknüpft, so dass bei Änderung der Ausgangssignale des Speicherelementes durch das ODER-Gatter 200 ein Signal mit einer steigenden Flanke erzeugt wird, welches als Taktsignal auf den Takteingang 212 des Flop-Flops 210 geführt wird. Aufgrund der Schaltverzögerung des ODER-Gatter 200 gelangt das Taktsignal zeitlich nach dem Datensignal am Eingang 211 zu dem Takteingang 212. Das Flip-Flop 210 wird somit sicher gesetzt.

Bei einer "1" am Ausgang 213 des Flip-Flops 210 liegt an den Eingängen I1 und I3 eine "1" an, die Eingänge I2 und I4 erhalten eine "0". Dies entspricht der ursprünglichen Programmierung, so dass der Zustand des Speicherelementes erhalten bleibt.

Nachdem die Daten in dem Flip-Flop 210 gespeichert wurden, wird das nicht-flüchtige Speicherelement in einen Stromsparmodus gebracht. In diesem wird das erste Steuersignal WE und das dritte Steuersignal VWELL auf die Versorgungsspannung VCC gelegt, die Transistoren 20, 30, 80 und 90 sind dadurch nicht-leitend und die Floating-Gate-Transistoren 40 und 50 werden von der Versorgungsspannung VCC getrennt. Außerdem sind die Transistoren 40 und 50 von den Ausgangsanschlüssen O1 und O2 getrennt. Wenn das zweite Steuersignal WE_LV auf VCC geht, werden beide n-Kanal-Transistoren 110 und 120 leitend und das Potential an den Ausgangsanschlüssen O1 und O2 geht auf Masse. Die Pegel der Steuersignale WE und WE_LV entsprechen somit den Pegeln in dem Schreib-Modus.

Der Ausgang 213 des Flip-Flops 210 ist mit den Eingangsanschlüssen I1 und I3 verbunden. Der komplementäre Ausgang 214 des Flip-Flops 210 ist mit den Eingangsanschlüssen I2 und I4 verbunden. Die in der Figur 8 gezeigten Schalter 220 und 230 sind dazu geschlossen. Im oben beschriebenen Stromsparmodus verbraucht das nicht-flüchtige Speicherelement lediglich einen Leckstrom.

Der Stromsparmodus wird beendet, wenn geänderte Daten in das Speicherelement geschrieben werden sollen. Dazu werden zunächst die Schalter 220 und 230 geöffnet, um zu verhindern, dass eine zum Schreiben verwendete Hochspannung, die an den Eingangsanschlüssen I1, I2, I3 oder I4 des Speicherelements anliegt, zu den Ausgängen 213 und 214 des Flip-Flops 210 gelangen kann. Anschließend können die neuen Daten geschrieben werden, wie oben beschrieben wurde.

Die Ansteuersignale für die Schalter 220 und 230 werden ebenso wie die Steuersignale WE, VWELL und WE_LV von einer externen Steuereinheit bereitgestellt.

Als Alternative zu der beschriebenen Anschlussbelegung des Speicherelementes und des Flip-Flops 210 kann natürlich auch der dritte Datenanschluss O1 mit dem Dateneingang 211 des Flip-Flops 210 verbunden sein. Entsprechend müsste die Beschaltung der Ausgänge 213 und 214 vertauscht werden.

Zum Verständnis eines weiteren Vorteils des Stromsparmodus bezüglich der Datenerhaltung ist eine Betrachtung der Spannungsverhältnisse in dem normalen Lese-Modus und in dem Stromsparmodus wichtig. Im Stromsparmodus wird das Steuer-Gate 55 des Transistors 50, das mit dem Knoten 18 verbunden ist, auf die Versorgungsspannung VCC gelegt, und der Kanalbereich ist mit Masse verbunden. Die Ladung des Floating-Gates 54 bleibt entsprechend seiner Programmierung in dem oben ausgeführten Beispiel negativ, sogar wenn das Floating-Gate aufgrund eines Gate-Kanal-Leckstroms nach einer langen Zeitdauer auf VCC entladen ist. Das Steuer-Gate des Transistors 40, das mit dem Knoten 16 verbunden ist, wird auf Masse und der Kanalbereich auf VCC gelegt. Die Ladung am Floating-Gate 44 des Transistors 40 bleibt positiv, auch wenn das Floating-Gate nach einer langen Zeitdauer durch Leckströme auf Masse entladen wird. Die ursprünglich programmierten Daten bleiben im Stromsparmodus trotz Leckströmen und Temperaturbelastungen erhalten.

Im normalen Lese-Modus liegt das Steuer-Gate 55 des Transistors 50 auf Masse und der Kanalbereich liegt auf VCC. Die Ladung auf dem Floating-Gate 54 des Transistors 50 wird wegen Leckströmen zwischen dem Gate und dem Kanal nach einer langen Zeitdauer positiv werden. Das Floating-Gate 54 war in dem oben genannten Beispiel jedoch ursprünglich negativ programmiert. Das Steuer-Gate 45 des Transistors 40 liegt auf VCC und der Kanalbereich auf Masse. Die Ladung des Floating-Gates 44 wird nach einer langen Zeitdauer aufgrund der Gate-Kanal-Leckströme negativ, war jedoch ursprünglich positiv programmiert. Dies führt zu einer Umkehrung der ursprünglich programmierten Zustände aufgrund des Gate-Kanal-Leckstroms und der Temperaturbelastungen, so dass die gespeicherten Daten verloren gehen.

Im Gegensatz zu dem normalen Lese-Modus bestehen in dem Stromsparmodus somit keine Probleme bezüglich der Datenhaltung über eine lange Zeitdauer.

Die Ausführungsbeispiele und Anwendungen dieser Erfindung wurden für Standard-CMOS-n-Substrat-Prozesse beschrieben. Es ist ebenso möglich, Speicherelemente als n-Kanal-Floating-Gate-Transistoren in einem p-Substrat-CMOS-Prozess herzustellen. Alle Ausführungen der Erfindung können einfach angepasst werden, um dieselbe Funktionalität im einem p-Substrat-Prozess zu erhalten.

### Bezugszeichenliste

- 5: dritte Steuersignalleitung
- 9: zweiter Steuersignalleitung
- 10: zweiter Versorgungsspannungsanschluss
- 12: erster Versorgungsspannungsanschluss
- 14: erste Steuersignalleitung
- 16, 18: Knoten
- 20, 30, 40, 50, 60, 70, 80, 90, 100, 110, 120: Transistoren
- 44, 54: Floating-Gates
- 200: Logikgatter
- 201: erster Eingang des Logikgatters
- 202: zweiter Eingang des Logikgatters
- 203: Ausgang des Logikgatters
- 210: Flip-Flop
- 211: Dateneingang des Flip-Flops
- 212: Takteingang des Flip-Flops
- 213: erster Ausgang des Flip-Flops
- 214: zweiter Ausgang des Flip-Flops
- 220, 230: Schalter
- I1/O1, I2/O2: Datenanschlüsse
- I1..I4: Datenanschlüsse
- O1, O2: Datenanschlüsse
- WE: erstes Steuersignal
- WE_LV: zweites Steuersignal
- VWELL: drittes Steuersignal

## Patentansprüche

1. Nicht-flüchtiges Speicherelement umfassend
- einen ersten und einen zweiten Datenanschluss (I1/O1, I2/O2; I1, I2),
- einen ersten und einen zweiten MOS-Transistor (60, 70) eines ersten Leitfähigkeitstyps,
- deren Source-Anschlüssen mit einem zweiten Versorgungsspannungsanschluss (10) verbunden sind,
- wobei ein Drain-Anschluss des ersten MOS-Transistors (60) mit dem ersten Datenanschluss (I1/O1; I1) verbunden ist und ein Drain-Anschluss des zweiten MOS-Transistors (70) mit dem zweiten Datenanschluss (I2/O2; I2) verbunden ist, und
- wobei der erste und zweite MOS-Transistor (60, 70) kreuzgekoppelte Gate-Anschlüsse zu den Drain-Anschlüssen des jeweils anderen des ersten und zweiten MOS-Transistors (70, 60) aufweisen,
- dritte und vierte Floating-Gate-MOS-Transistoren (40, 50) eines zweiten Leitfähigkeitstyps,
- wobei ein Drain-Anschluss des dritten MOS-Transistors (40) mit dem ersten Datenanschluss (I1/O1; I1) verbunden ist und ein Drain-Anschluss des vierten MOS-Transistors (50) mit dem zweiten Datenanschluss (I2/O2; I2) verbunden ist,
- wobei der dritte und vierte MOS-Transistor (40, 50) Steuergate-Anschlüsse (45, 55) aufweisen, die zu den Drain-Anschlüssen des jeweils anderen des dritten und vierten MOS-Transistors (50, 40) kreuzgekoppelt sind,
- einen fünften und einen sechsten MOS-Transistor (20, 30) des zweiten Leitfähigkeitstyps,
- deren Source-Anschlüsse mit einem ersten Versorgungsspannungsanschluss (12) verbunden sind und
- deren Gate-Anschlüsse mit einer ersten gemeinsamen Steuersignalleitung (14) verbunden sind,
- wobei ein Drain-Anschluss des fünften MOS-Transistors (20) mit dem Source-Anschluss des dritten MOS-Transistors (50) und ein Drain-Anschluss des sechsten MOS-Transistors (30) mit dem Source-Anschluss des vierten MOS-Transistors (50) verbunden ist;
**dadurch gekennzeichnet, daß** die well-Anschlüsse des füngten und sechten MOS-Transistors mit einer dritten gemeinsamen Steuersignalleitung (5) verbunden sind zur Beaufschlagung der Well-Anschlüsse in einem Schreib- Modus mit einer Programmierspannung und in einem Lese- Modus mit der ersten Versorgungsspannung.

2. Nicht-flüchtiges Speicherelement nach Anspruch 1,
**dadurch gekennzeichnet, dass**
- ein siebter und ein achter MOS-Transistor (80, 90) des zweiten Leitfähigkeitstyps vorgesehen sind, deren Gate-Anschlüsse mit der ersten gemeinsamen Schaltleitung (14) verbunden sind, deren Well-Anschlüsse mit der dritten gemeinsamen Steuerleitung (5) verbunden sind,
- wobei der siebte MOS-Transistor (80) mit seinen Lastanschlüssen zwischen den ersten Datenanschluss (I1) und den Drain-Anschluss des ersten MOS-Transistors (60) geschaltet ist,
- wobei der achte MOS-Transistor (90) mit seinen Lastanschlüssen zwischen den zweiten Datenanschluss (I2) und den Drain-Anschluss des zweiten MOS-Transistors (70) geschaltet ist,
- wobei der Drain-Anschluss des ersten MOS-Transistors (60) mit einem dritten Datenanschluss (O1) verbunden ist, der einen Datenausgang bildet, und
- wobei der Drain-Anschluss des zweiten MOS-Transistors (60) mit einem vierten Datenanschluss (O2) verbunden ist, der einen Datenausgang bildet.

3. Nicht-flüchtiges Speicherelement nach einem der Ansprüche 1 oder 2,
**dadurch gekennzeichnet, dass** der Source-Anschluss des dritten MOS-Transistors (40) mit einem fünften Datenanschluss (I3) und der Source-Anschluss des vierten MOS-Transistors (50) mit einem sechsten Datenanschluss (I4) verbunden ist.

4. Nicht-flüchtiges Speicherelement nach Anspruch 2,
**dadurch gekennzeichnet, dass** ein neunter MOS-Transistor (100) des ersten Leitfähigkeitstyps vorgesehen ist, dessen Drain-Anschluss mit dem dritten Datenanschluss (O1), dessen Source-Anschluss mit dem vierten Datenanschluss (O2) und dessen Gate-Anschluss mit einer zweiten gemeinsamen Schaltleitung (9) verbunden sind.

5. Nicht-flüchtiges Speicherelement nach Anspruch 2,
**gekennzeichnet durch**
einen zehnten und einen elften MOS-Transistor (120, 110) des ersten Leitfähigkeitstyps,
- deren Source-Anschlüsse mit dem ersten Versorgungsspannungsanschluss (10) und
- deren Gate-Anschlüsse mit einer zweiten gemeinsamen Schaltleitung (9) verbunden sind,
- wobei der Drain-Anschluss des zehnten MOS-Transistor (120) mit dem dritten Datenanschluss (O1) verbunden ist und der Drain-Anschluss des elften MOS-Transistor (110) mit dem vierten Datenanschluss (O2) verbunden ist.

6. Anordnung mit einem nicht-flüchtigen Speicherelement nach einem der Ansprüche 2 oder 5 und einem Logikgatter (200), das eingangsseitig mit dem dritten und dem vierten Datenanschluss (O1, O2) verbunden ist, wobei durch das Logikgatter (200) ein Wechsel der Ausgangssignale an dem dritten und dem vierten Datenanschluss (O1, O2) feststellbar ist.

7. Anordnung mit einem nicht-flüchtigen Speicherelement nach Anspruch 3 und einem Logikgatter (200), das eingangsseitig mit dem dritten und dem vierten Datenanschluss (O1, O2) verbunden ist, wobei durch das Logikgatter (200) ein Wechsel der Ausgangssignale an dem dritten und dem vierten Datenanschluss (O1, O2) feststellbar ist.

8. Anordnung nach Anspruch 6,
**dadurch gekennzeichnet, dass**
- ein Flip-Flop (210) vorgesehen ist,
- der vierte Datenanschluss (O2) mit einem Dateneingang (211) des Flip-Flops (210) verbunden ist,
- ein Ausgang (203) des Logik-Gatters (200) mit einem TaktEingang (212) des Flip-Flops (210) verbunden ist,
- ein erster Ausgang (213) des Flip-Flops (210) über einen ersten Schalter (220) mit dem ersten und dem fünften Datenanschluss (I1, I3) des nicht-flüchtigen Speicherelements verbunden ist,
- ein zweiter, komplementärer Ausgang (214) des Flip-Flops (210) über einen zweiten Schalter (230) mit dem zweiten und sechsten Datenanschluss (I2, I4) des nicht-flüchtigen Speicherelements verbunden ist.

9. Anordnung nach Anspruch 7,
**dadurch gekennzeichnet, dass**
- ein Flip-Flop (210) vorgesehen ist,
- der vierte Datenanschluss (02) mit einem Dateneingang (211) des Flip-Flops (210) verbunden ist,
- ein Ausgang (203) des Logik-Gatters (200) mit einem TaktEingang (212) des Flip-Flops (210) verbunden ist,
- ein erster Ausgang (213) des Flip-Flops (210) über einen ersten Schalter (220) mit dem ersten und dem fünften Datenanschluss (I1, I3) des nicht-flüchtigen Speicherelements verbunden ist,
- ein zweiter, komplementärer Ausgang (214) des Flip-Flops (210) über einen zweiten Schalter (230) mit dem zweiten und sechsten Datenanschluss (I2, I4) des nicht-flüchtigen Speicherelements verbunden ist.

## Claims

1. Non-volatile storage element comprising
- a first and a second data terminal (I1/O1; I2/O2; I1, I2),
- a first and a second MOS transistor (60, 70) of a first conductivity type,
- whose source terminals are connected to a second supply-voltage terminal (10),
- where a drain terminal of the first MOS transistor (60) is connected to the first data terminal (I1/O1; I1), and a drain terminal of the second MOS transistor (70) is connected to the second data terminal (I2/O2; I2), and
- where the first and second MOS transistors (60, 70) have cross-coupled gate terminals to the drain terminals of the respective other of the first and second MOS transistor (70, 60),
- third and fourth floating-gate MOS transistors (40, 50) of a second conductivity type,
- where a drain terminal of the third MOS transistor (40) is connected to the first data terminal (I1/O1; I1), and a drain terminal of the fourth MOS transistor (50) is connected to the second data terminal (I2/O2; I2),
- where the third and fourth MOS transistor (40, 50) has control-gate terminals (45, 55), which are cross-coupled to the drain terminals of the respective other of the third and fourth MOS transistor (50, 40),
- a fifth and a sixth MOS transistor (20, 30) of the second conductivity type,
- whose source terminals are connected to a first supply-voltage terminal (12), and
- whose gate terminals are connected to a first common control signal line (14),
- where a drain terminal of the fifth MOS transistor (20) is connected to the source terminal of the third MOS transistor (50), and a drain terminal of the sixth MOS transistor (30) is connected to the source terminal of the fourth MOS transistor (50),
**characterized in that** the well terminals of the fifth and sixth MOS transistor are connected to a third common control signal line (5) for applying a programming voltage to the well terminals in a write mode and the first supply voltage in a read mode.

2. Non-volatile storage element according to Claim 1,
**characterized in that**
- a seventh and an eighth MOS transistor (80, 90) of the second conductivity type are provided, whose gate terminals are connected to the first common switching line (14), whose well terminals are connected to the third common control line (5),
- where the seventh MOS transistor (80) is connected by its load terminals between the first data terminal (I1) and the drain terminal of the first MOS transistor (60),
- where the eighth MOS transistor (90) is connected by its load terminals between the second data terminal (I2) and the drain terminal of the second MOS transistor (70),
- where the drain terminal of the first MOS transistor (60) is connected to a third data terminal (O1 forming a data output, and
- where the drain terminal of the second MOS transistor (70) is connected to a fourth data terminal (O2) forming a data output.

3. Non-volatile storage element according to any of Claims 1 or 2,
**characterized in that** the source terminal of the third MOS transistor (40) is connected to a fifth data terminal (I3), and the source terminal of the fourth MOS transistor (50) is connected to a sixth data terminal (I4).

4. Non-volatile storage element according to Claim 2,
**characterized in that** a ninth MOS transistor (100) of the first conductivity type is provided, whose drain terminal is connected to the third data terminal (O1), whose source terminal is connected to the fourth data terminal (O2), and whose gate terminal is connected to a second common switching line (9).

5. Non-volatile storage element according to Claim 2,
**characterized by** a tenth and an eleventh MOS transistor (120, 110) of the first conductivity type,
- whose source terminals are connected to the first supply-voltage terminal (10), and
- whose gate terminals are connected to a second common switching line (9),
- where the drain terminal of the tenth MOS transistor (120) is connected to the third data terminal (O1), and the drain terminal of the eleventh MOS transistor (110) is connected to the fourth data terminal (O2).

6. Arrangement comprising a non-volatile storage element according to any of Claims 2 to 5, and a logic gate (200), which is connected on the input side to the third and the fourth data terminal (O1, O2), where a change in the output signals at the third and the fourth data terminal (O1, O2) can be detected by the logic gate (200).

7. Arrangement comprising a non-volatile storage element according to Claim 3, and a logic gate (200), which is connected on the input side to the third and the fourth data terminal (O1, O2), where a change in the output signals at the third and the fourth data terminal (O1, O2) can be detected by the logic gate (200).

8. Arrangement according to Claim 6,
**characterized in that**
- a flip-flop (210) is provided,
- the fourth data terminal (O2) is connected to a data input (211) of the flip-flop (210),
- an output (203) of the logic gate (200) is connected to a clock input (212) of the flip-flop (210),
- a first output (213) of the flip-flop (210) is connected via a first switch (220) to the first and the fifth data terminal (I1, I3) of the non-volatile storage element,
- a second, complementary output (214) of the flip-flop (210) is connected via a second switch (230) to the second and sixth data terminal (I2, I4) of the non-volatile storage element.

9. Arrangement according to Claim 7,
**characterized in that**
- a flip-flop (210) is provided,
- the fourth data terminal (02) is connected to a data input (211) of the flip-flop (210),
- an output (203) of the logic gate (200) is connected to a clock input (212) of the flip-flop (210),
- a first output (213) of the flip-flop (210) is connected via a first switch (220) to the first and the fifth data terminal (I1, I3) of the non-volatile storage element,
- a second, complementary output (214) of the flip-flop (210) is connected via a second switch (230) to the second and sixth data terminal (I2, I4) of the non-volatile storage element.

## Revendications

1. Elément de mémoire non volatil comprenant
- une première et une deuxième borne (I1/O1, I2, O2 ; I1, I2) de données,
- un premier et un deuxième transistor (60, 70) MOS d'un premier type de conductivité,
- dont les bornes de source sont reliées à une deuxième borne (10) de tension d'alimentation,
- dans lequel une borne de drain du premier transistor (60) MOS est reliée à la première borne (I1/O1 ; I1) de données et une borne de drain du deuxième transistor (70) MOS est reliée à la deuxième borne (I2/O2 ; I2) de données, et
- dans lequel le premier et le deuxième transistor (60, 70) MOS ont des bornes de grille, qui sont couplées en croix aux bornes de drain de respectivement l'autre des premier et deuxième transistors (70, 60) MOS,
- des troisième et quatrième transistors (40, 50) MOS flottants d'un deuxième type de conductivité,
- dans lequel une borne de drain du troisième transistor (40) MOS est reliée à la première borne (I1/O1 ; I1) de données et une borne de drain du quatrième transistor (50) MOS est reliée à la deuxième borne (I2/O2 ; I2) de données,
- dans lequel le troisième et le quatrième transistor (40, 50) MOS ont des bornes (45, 55) de grille de commande, qui sont couplées en croix aux bornes de drain de respectivement l'autre des troisième et quatrième transistors (50, 40) MOS,
- un cinquième et un sixième transistor (20, 30) MOS du deuxième type de conductivité,
- dont les bornes de source sont reliées à une première borne (12) de tension d'alimentation et
- dont les bornes de grille sont reliées à une première ligne (14) commune de signal de commande,
- dans lequel une borne de drain du cinquième transistor (20) MOS est reliée à la borne de source du troisième transistor (50) MOS et une borne de drain du sixième transistor (30) MOS est reliée à la borne de source du quatrième transistor (50)MOS,
**caractérisé en ce que** les bornes de puits des cinquième et sixième transistors MOS sont reliées à une troisième ligne (5) commune de signal de commande pour l'application aux bornes de puits dans un mode d'écriture d'une tension de programmation et dans un mode de lecture de la première tension d'alimentation.

2. Elément de mémoire non volatil suivant la revendication 1,
**caractérisé en ce que**
- il est prévu un septième et un huitième transistor (80, 90) MOS du deuxième type de conductivité, dont les bornes de grille sont reliées à la première ligne (14) de commutation, dont les bornes de puits sont reliées à la troisième ligne (5) commune de commande,
- dans lequel le septième transistor (80) MOS est monté par ses bornes de charge entre la première borne (I1) de données et la borne de drain du premier transistor (60) MOS,
- dans lequel le huitième transistor (90) MOS est monté par ses bornes de charge entre la deuxième borne (I2) de données et la borne de drain du deuxième transistor (70) MOS,
- dans lequel la borne de drain du premier transistor (60) MOS est reliée à une troisième borne (O1) de données qui forme une sortie de données, et
- dans lequel la borne de drain du deuxième transistor (60) MOS est reliée à une quatrième borne (O2) de données qui forme une sortie de données.

3. Elément de mémoire non volatil suivant l'une des revendications 1 ou 2,
**caractérisé en ce que** la borne de source du troisième transistor (40) MOS est reliée à une cinquième borne (I3) de données et la borne de source du quatrième transistor (50) MOS est reliée à une sixième borne (I4) de données.

4. Elément de mémoire non volatil suivant la revendication 2,
**caractérisé en ce qu'**il est prévu un neuvième transistor (100) MOS du premier type de conductivité dont la borne de drain est reliée à la troisième borne (O1) de données, dont la borne de source est reliée à la quatrième borne (02) de données et dont la borne de grille est reliée à une deuxième ligne (9) commune de commutation.

5. Elément de mémoire non volatil suivant la revendication 2,
**caractérisé par**
un dixième et un onzième transistor (120, 110) MOS du premier type de conductivité,
- dont les bornes de source sont reliées à la première borne (10) de tension d'alimentation et
- dont les bornes de grille sont reliées à une deuxième ligne (9) commune de commutation,
- dans lequel la borne de drain du dixième transistor (120) MOS est reliée à la troisième borne (O1) de données et la borne de drain du onzième transistor (110) MOS est reliée à la quatrième borne (O2) de données.

6. Dispositif ayant un élément de mémoire non volatil suivant l'une des revendications 2 ou 5 et une porte (200) logique qui est reliée du côté de l'entrée à la troisième et à la quatrième borne (O1, O2) de données, dans lequel un changement des signaux de sortie sur la troisième et la quatrième borne (O1, O2) de données peut être constaté par la porte (200) logique.

7. Dispositif ayant un élément de mémoire non volatil suivant la revendication 3 et une porte (200) logique, qui est reliée du côté de l'entrée à la troisième et à la quatrième borne (O1, O2) de données, dans lequel un changement des signaux de sortie sur la troisième et la quatrième borne (O1, O2) de données peut être constaté par la porte (200) logique.

8. Dispositif suivant la revendication 6,
**caractérisé en ce que**
- il est prévu une bascule (210),
- la quatrième borne (02) de données est reliée à une entrée (211) de données de la bascule (210),
- une sortie (203) de la porte (200) logique est reliée à une entrée (212) d'horloge de la bascule (210),
- une première sortie (213) de la bascule (210) est reliée par un premier interrupteur (220) à la première et à la cinquième borne (I1, I3) de données de l'élément de mémoire non volatil,
- une deuxième sortie (214) complémentaire de la bascule (210) est reliée par un deuxième interrupteur (230) à la deuxième et à la sixième borne (I2, I4) de données de l'élément de mémoire non volatil.

9. Dispositif suivant la revendication 7,
**caractérisé en ce que**
- il est prévu une bascule (210),
- la quatrième borne (O2) de données est reliée à une entrée (211) de données de la bascule (210),
- une sortie (203) de la porte (200) logique est reliée à une entrée (212) d'horloge de la bascule (210),
- une première sortie (213) de la bascule (210) est reliée par un premier interrupteur (220) à la première et à la cinquième borne (I1, I3) de données de l'élément de mémoire non volatil,
- une deuxième sortie (214) complémentaire de la bascule (210) est reliée par un deuxième interrupteur (230) à la deuxième et à la sixième borne (I2, I4) de données de l'élément de mémoire non volatil.
